# EUROPÄISCHE PATENTSCHRIFT

(11) **EP 1 245 051 B1**
(45) Veröffentlichungstag und Bekanntmachung des Hinweises auf die Patenterteilung: **21.09.2011**
(21) Anmeldenummer: 00989778.6
(22) Anmeldetag: 17.11.2000
(51) Int. Cl.: H01L 29/78

(54) **VERPOLUNGSSICHERER DMOS-TRANSISTOR**
DMOS TRANSISTOR PROTECTED AGAINST POLARITY REVERSAL
TRANSISTOR DMOS PROTEGE CONTRE LES INVERSIONS DE POLARITE

(30) Priorität: 18.12.1999 DE 19961297
(43) Veröffentlichungstag der Anmeldung: 02.10.2002
(73) Patentinhaber: ROBERT BOSCH GMBH, 70442 Stuttgart (DE)
(72) Erfinder: PLIKAT, Robert, 71665 Vaihingen/Enz (DE); FEILER, Wolfgang, 72766 Reutlingen (DE)
(86) Internationale Anmeldenummer: PCT/DE2000/004044
(87) Internationale Veröffentlichungsnummer: WO 2001/045176

(56) Entgegenhaltungen:
- WO-A-99/26296
- US-A- 4 101 922
- US-A- 5 438 215

## Beschreibung

Die Erfindung betrifft eine Schaltungsanordnung zur Verpolsicherung eines DMOS-Transistors.

### Stand der Technik

Werden DMOS-Transistoren in Schaltungsanordnungen eingesetzt, in denen wenigstens zwei Versorgungsspannungen zur Verfügung stehen, kann es infolge eines Fehlerfalls, beispielsweise eines Kurzschlusses, zum Rückwärts-Fließen eines Kurzschluss-Stromes über den DMOS-Transistor kommen. Insbesondere bei hohen Kurzschluss-Strömen kann es hierdurch zu einer Zerstörung des DMOS-Transistors beziehungsweise einer vorgelagerten Spannungsversorgung kommen.

Aus der DE 195 02 731 C2 ist eine Schaltungsanordnung bekannt, bei der einem mit einem zu schaltenden Verbraucher in Reihe liegenden DMOS-Transistor ein Verpolschutz-DMOS-Transistor zugeordnet ist. Die Transistoren sind hierbei antiseriell verschaltet und in einem gemeinsamen Substrat monolithisch integriert. Dadurch, dass sowohl der Schalttransistor als auch der Verpolschutz-Transistor in einem gemeinsamen, eine bestimmte Ladungsträgerdotierung aufweisendes Substrat integriert sind, besitzen beide Transistoren eine gleiche Sperrfestigkeit. Diese Sperrfestigkeit wird so gewählt, dass die maximal mögliche Spannung blockiert werden kann. Neben dem hohen Flächenbedarf ist bei dieser Schaltungsanordnung nachteilig, dass die hohe Sperrfestigkeit des Schalttransistors zu einem entsprechend hohen Durchlasswiderstand im Leitungsfalle führt, der zu einem an sich unerwünschten Spannungsabfall führt.

Aus der US 4,101,922 A ist ein Feldeffekttransistor bekannt, der durch geeignete Strukturierung der Source- und Drain-Anschlüsse in einem Halbleitersubstrat gebildet wird. Zur Realisierung des Feldeffekttransistors werden zwischen dem Source- und dem Drain-Anschluss durch einen Dotierungsvorgang Bereiche erzeugt, die durch eine Höherdotierung des Substratmaterials einen Channel definieren. Über eine elektrische Beeinflussung dieses Channels lässt sich dann der Fluss vom Source- zum Drain-Anschluss steuern.

Aus der US 5,438,215 A ist ein hochsperrender Leistungs-MOSFET bekannt, bei dem der Durchlaßwiderstand dadurch herabgesetzt wird, dass in der Innenzone im Bereich der Raumladungszone höher dotierte Zonen eines gegenüber der in der Innenzone entgegengesetzten Leitungstyp angeordnet ist. Zwischen diesen Zonen mit entgegengesetztem Leitungstyp liegen weitere Zonen, die den Leitungstyp der Innenzone, jedoch mit höherer Dotierung aufweisen. Durch das Anlegen einer Nennsperrspannung werden die Ladungsträger aus den zusätzlichen Zonen des Blocks ausgeräumt, wodurch sich der Durchlaßwiderstand einstellen lässt.

Aus der WO 99/26296 A2 ist eine MISFET-Halbleiteranordnung bekannt, bei der eine Schutzschaltung gegenüber höher Spannungen im Sperrzustand vorgesehen ist. Diese Schaltung wird durch einen vergrabenen Bereich eines ersten Leitungstyps in einer Schicht eines entgegengesetzten zweiten Leitungstyps erzeugt. Durch diesen vergrabenen Bereich wird das elektrische Feld in der zu schützenden Schaltung reduziert, so dass die entsprechenden Schichten dünner ausgelegt werden können.

### Vorteile der Erfindung

Die erfindungsgemässe Schaltungsanordnung mit den in Anspruch 1 genannten Merkmalen bietet demgegenüber den Vorteil, dass in einfacher Weise eine Verpolsicherung des DMOS-Transistors erreicht wird. Dadurch, dass im Driftgebiet des DMOS-Transistors ein Ladungsträgergebiet angeordnet ist, das aus einzelnen, beabstandet zueinander angeordneten und leitfähig miteinander verbundenen Teil-Ladungsträgergebiete besteht, wobei das LadungsVägergebiet gegenüber dem Driftgebiet eine entgegengesetzte Ladungsträgerdotierung aufweist und mit einem, zu einem am Drainanschluss des DMOS-Transistors anlegbaren Potential negativen Potential beaufschlagbar ist, wird vorteilhaft erreicht, im Wesentlichen ohne zusätzlichen Platzbedarf, eine Rückwärts-Sperrfähigkeit des DMOS- Transistors zu erzielen. Durch Beaufschlagen des eine JFET-Struktur bildenden vergrabenen Ladungsträgergebietes mit einem negativen Potential gegenüber dem Drainpotential wird der pn-Übergang zwischen dem Draingebiet und dem im Draingebiet angeordneten Ladungsträgergebiet sperrgepolt, so dass ein sogenannter Rückwärts-Strom, beispielsweise im Kurzschlussfalle, abgeschnürt ist. Somit wird die Verpolsicherheit der gesamten Schaltungsanordnung sichergestellt.

Bevorzugte Ausgestaltungen der Erfindung ergeben sich aus den übrigen, in den Unteransprüchen genannten Merkmalen.

### Zeichnungen

Die Erfindung wird nachfolgend in Ausführungsbeispielen anhand der zugehörigen Zeichnungen näher erläutert. Es zeigen:
- Figur 1: eine schematische Ansicht der erfindungsge- mäßen Schaltungsanordnung;
- Figuren 2 bis 5: Herstellungsschritte zum Erzielen der Schaltungsanordnung gemäß Figur 1;
- Figur 6: eine erfindungsgemäße Schaltungsanordnung in einem zweiten Ausführungsbeispiel;
- Figur 7: eine erfindungsgemäße Schaltungsanordnung in einem dritten Ausführungsbeispiel und
- Figuren 8 bis 10: verschiedene Layouts der erfindungsgemäß integrierten Ladungsträgergebiete.

### Beschreibung der Ausführungsbeispiele

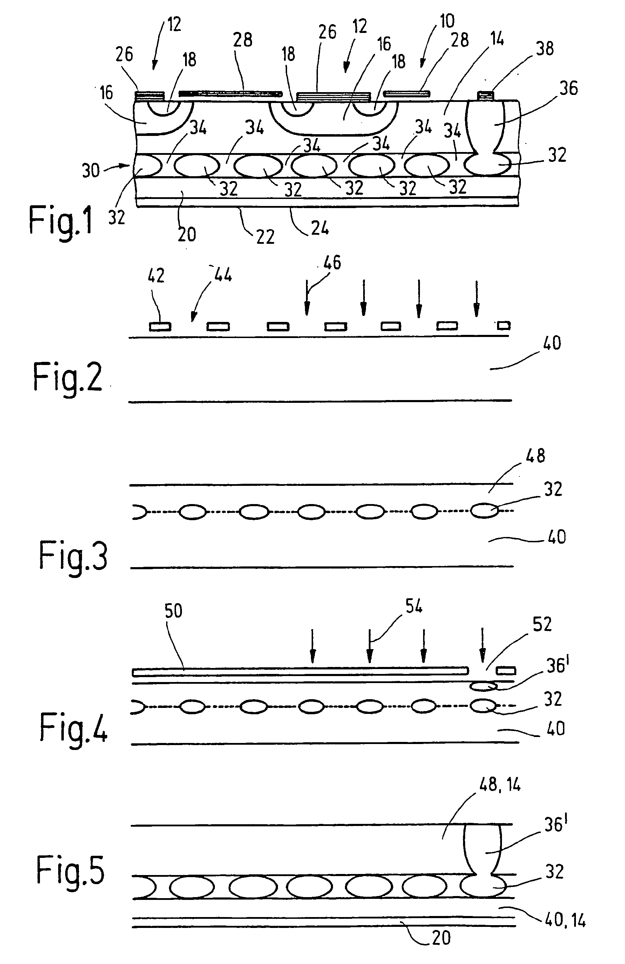

Figur 1 zeigt einen DMOS-Transistor 10. Der DMOS-Transistor ist ausschnittsweise im Bereich zweier Steuerköpfe 12 in einer schematischen Schnittdarstellung gezeigt.

Der DMOS-Transistor 10 umfasst ein Driftgebiet 14 mit einer Ladungsträgerdotierung (beispielsweise n-dotiert). In das Driftgebiet 14 sind Ladungsträgergebiete 16 mit einer zur ersten Ladungsträgerdotierung entgegengesetzten Ladungsträgerdotierung (im Beispiel p-dotiert) integriert. In die Ladungsträgergebiete 16 sind weitere Ladungsträgergebiete 18 integriert, die die gleiche Ladungsträgerdotierung wie das Driftgebiet 14 aufweisen (im Beispiel n⁺-dotiert). Das Driftgebiet 14 ist auf einem Substratgebiet 20 angeordnet, das dem gleichen Ladungsträgertyp wie das Driftgebiet 14 entspricht, jedoch eine höhere Dotierung aufweist (im Beispiel n⁺-dotiert). Das Substratgebiet 20 ist mit einer Metallisierung 22 versehen. Die Metallisierung bildet einen Drainanschluss 24 des DMOS-Transistors 10. Die Ladungsträgergebiete 16 und 18 sind über Metallisierungen 26 elektrisch leitend verbunden. Die Metallisierungen 26 bilden Sourceanschlüsse des DMOS-Transistors 10. Eine vorzugsweise aus Polysilizium bestehende Schicht 28 ist über ein nicht dargestelltes Oxid auf dem Driftgebiet 14 angeordnet und bildet das Gate des DMOS-Transistors 10.

Der Sourceanschluss 26 des DMOS-Transistors 10 ist mit einem nicht dargestellten elektrischen Verbraucher verbunden, der andererseits an Masse liegt. Eine Versorgungsspannung für den elektrischen Verbraucher liegt am Drainanschluss an.

In das Driftgebiet 14 ist ein Ladungsträgergebiet 30 integriert, das aus einzelnen, beabstandet zueinander angeordneten Teil-Ladungsträgergebieten 32 besteht. Die Teil-Ladungsträgergebiete 32 sind elektrisch leitend miteinander verbunden. Zwischen den einzelnen Teil-Ladungsträgergebieten 32 verbleiben Abschnitte (Lücken) 34 des Driftgebietes 14, so dass die Teil-Ladungsträgergebiete 32 eine gitterartige Struktur über die Fläche des Driftgebietes 14 ausbilden. Die Teil-Ladungsträgergebiete 32 und somit das gesamte Ladungsträgergebiet 30 besitzen eine Ladungsträgerdotierung, die der Ladungsträgerdotierung des Driftgebietes 14 entgegengesetzt ist (im Beispiel somit p-dotiert). Das Ladungsträgergebiet 30 ist über ein vertikales Ladungsträgergebiet 36 mit einer Metallisierung 38 elektrisch leitend verbunden. Das Ladungsträgergebiet 36 besitzt die gleiche Dotierung wie das Ladungsträgergebiet 30. Zur Kontaktierung des Ladungsträgergebietes 30 kann das Ladungsträgergebiet 36 - wie dargestellt - das Driftgebiet 14 zwischen der Metallisierung 38 und einem der Teil-Ladungsträgergebiete 32 überbrücken.

Der in Figur 1 dargestellte DMOS-Transistor 10 zeigt folgende Funktion:
Soll der an dem Sourceanschluss 26 angeschlossene elektrische Verbraucher mit der Versorgungsspannung verbunden werden, erfolgt dies durch Ansteuerung des Gateanschlusses 28. Der DMOS-Transistor 10 übt hierdurch seine an sich bekannte Schaltfunktion aus. Im Fehlerfalle, das heißt, am Sourceanschluss 26 liegt durch einen Kurzschluss eine höhere Spannung an als am Drainanschluss 24, wird dies durch eine nicht näher dargestellte Schaltungslogik erkannt. Hierauf wird die Metallisierung 38 mit einem gegenüber dem Drainanschluss 24 negativen Potential beaufschlagt. Hierdurch werden die pn-Übergänge zwischen den Teil-Ladungsträgergebieten 32 und dem Driftgebiet 14 sperrgepolt, so dass ein im Kurzschlussfalle vom Sourceanschluss 26 zum Drainanschluss 24 fließender Rückstrom abgeschnürt wird. Das durch die Schaltungslogik an die Metallisierung 38 angelegte Potential ist in seiner Höhe so gewählt, dass eine Ladungsträgerinjektion aus dem Ladungsträgergebiet 30 nicht eintritt. Entscheidend ist die Sperrpolung der pn-Übergänge zwischen den Teil-Ladungsträgergebieten 32 und dem Driftgebiet 14 im Fehlerfalle.

Anhand der Figuren 2 bis 5 wird schematisch der Herstellungsprozess der vergrabenen JFET-Strukturen bis zur üblichen Weiterprozessierung der DMOS-Strukturen des DMOS-Transistors 10 verdeutlicht.

Zunächst wird, wie Figur 2 zeigt, auf einem Ausgangswafer 40, der aus einem n⁺-dotierten Substrat und einer dünnen (üblicherweise wenige µm dicken) n-dotierten Schicht, die später Teile der Gebiete 34 und 32 aufnimmt, besteht (späteres Driftgebiet 14), eine Maskierung 42 angeordnet, die im Bereich der späteren Teil-Ladungsträgergebiete 32 Maskenöffnungen 44 besitzt. Anschließend erfolgt eine Ionenimplantation 46 mit p-dotierenden Ionen, die zur Ausbildung der Teil-Ladungsträgergebiete 32 führen. Figur 3 zeigt die Implantation der p-dotierten Teil-Ladungsträgergebiete 32 in dem Substrat 40. Nachfolgend wird eine n-dotierte, einkristalline Schicht 48 epitaktisch aufgewachsen, so dass die Teil-Ladungsträgergebiete 32 komplett im späteren Driftgebiet 14 vergraben angeordnet sind.

Anschließend erfolgt eine weitere Maskierung 50, wie Figur 4 verdeutlicht, die eine Maskenöffnung 52 im Bereich des späteren Ladungsträgergebietes 36 aufweist. Anschließend erfolgt eine Ionenimplantation 54 mit wiederum p-dotierenden Ionen, so dass es zur Ausbildung eines vorläufigen Teil-Ladungsträgergebietes 36' im Bereich der Maskenöffnung 52 kommt. Anschließend wird, wie Figur 5 verdeutlicht, das epitaktische Aufwachsen der n-dotierten einkristallinen Schicht 48 bis zum Erreichen der endgültigen Dicke der Driftzone 14 fortgesetzt.

Die Implantation der p-dotierten Teil-Ladungsträgergebiete 32 in ihrer strukturellen Anordnung erfolgt derart, dass bei Anlegen einer negativen Sperrspannung - wie anhand von Figur 1 bereits erläutert - der Rückwärts-Strompfad zwischen Sourceanschluss 12 und Drainanschluss 24 gesperrt wird. Im Durchlassfalle, also im normalen Schaltfalle des DMOS-Transistors 10, ist zur Einstellung eines optimalen Durchlassverhaltens eine Justierung der Teil-Ladungsträgergebiete 32 zu den MOS-Steuerköpfen (Ladungsträgergebiete 16, 18) des DMOS-Transistors 10 so vorgesehen, dass der sich einstellende Strompfad möglichst niederohmig ausgeführt ist.

Für das epitaktische Aufwachsen der Schicht 48 ist die n-Dotierung so gewählt, dass sowohl für die späteren MOS-Steuerköpfe des Transistors 10 als auch die Teil-Ladungsträgergebiete 32 eine gewünschte Sperrspannung erreicht ist. Diese Sperrspannung wird durch die Schichtdicke und Dotierung der Schicht 48 eingestellt.

Nach dem in Figur 5 verdeutlichten Zwischenschritt zur Herstellung des DMOS-Transistors 10 erfolgt mittels bekannter Standardfertigungsverfahrensschritte die Diffusion der Ladungsträgergebiete 16 und 18 und es werden Metallisierungen 22, 26 und 38 abgeschieden und die Polysiliziumabscheidung der Gateanschlüsse 28 aufgebracht. Gleichzeitig werden nicht näher dargestellte weitere Schaltungsbestandteile, beispielsweise eine Ansteuerschaltung, die bereits erwähnte Logik zur Erkennung des Fehlerfalls und die Ansteuerung der Metallisierung 38, erzeugt.

Durch die während dieser Standardprozess-Schritte auftretenden Temperatureinflüsse (zur Beeinflussung der Konzentrationsprofile der implantierten Ladungsträger) erfolgt eine Ausdiffusion der Teil-Ladungsträgergebiete 32 beziehungsweise des Ladungsträgergebietes 36 zu ihrer endgültigen Größe, so dass sich die Abstände zwischen den Teil-Ladungsträgergebieten 32 einstellen und sich die Kontaktierung des einen Teil-Ladungsträgergebietes 32 mit der Metallisierung 38 über das Teil-Ladungsträgergebiet 36 ergibt.

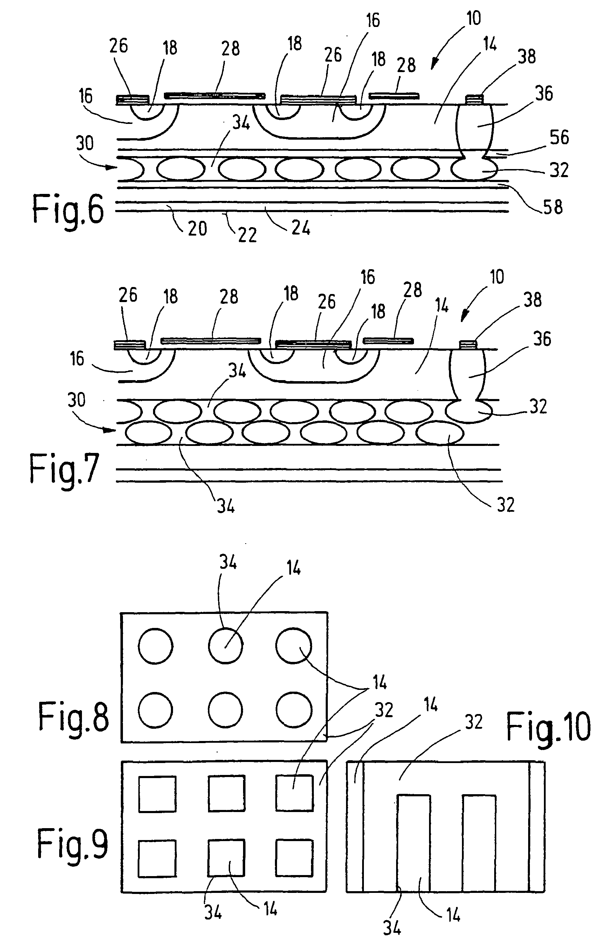

In Figur 6 ist eine weitere Ausführungsvariante des DMOS-Transistors 10 gezeigt. Gleiche Teile wie in Figur 1 sind mit gleichen Bezugszeichen versehen und nicht nochmals erläutert. Der Unterschied zu dem in Figur 1 gezeigten Ausführungsbeispiel besteht darin, dass ober- beziehungsweise unterhalb des Ladungsträgergebietes 30 innerhalb des Driftgebietes 14 eine Ladungsträgerschicht 56 beziehungsweise 58 strukturiert wurde. Die Ladungsträgerschicht 56 und 58 besitzt den gleichen Ladungsträgertyp wie das Driftgebiet 14, ist jedoch gegenüber diesem höher dotiert (im Beispiel demnach n-dotiert).

Bei dem in Figur 7 gezeigten Ausführungsbeispiel besteht das Ladungsträgergebiet 30 aus in zwei Ebenen angeordneten Teil-Ladungsträgergebieten 32. Die Teil-Ladungsträgergebiete 32 sind hierbei so angeordnet, dass diese versetzt angeordnet sind. Das heißt, einer Lücke 34 zwischen zwei Teil-Ladungsträgergebieten 32 und einer Ebene ist immer ein Teil-Ladungsträgergebiet des der darunter beziehungsweise darüber liegenden Ebene zugeordnet. Die in beiden Ebenen angeordneten Gebiete 32 sind elektrisch miteinander so verbunden, dass sie über den gemeinsamen Steueranschluss 38 angesteuert werden können. Hierdurch wird eine besonders effektive Abschnürung des Rückwärts-Strompfades des DMOS-Transistors 10 im Fehlerfalle möglich.

Die Figuren 8 bis 10 zeigen schließlich verschiedene Layout-Varianten der Strukturierung der Teil-Ladungsträgergebiete 32 innerhalb des Driftgebietes 14. Gemäß Figur 8 sind die Lücken 34 des Driftgebietes 14 zwischen dem Teil-Ladungsträgergebieten 32 im Wesentlichen rund ausgebildet, während die Lücken 34 gemäß dem in Figur 9 gezeigten Ausführungsbeispiel im Wesentlichen quadratisch ausgebildet sind. Gemäß dem in Figur 10 gezeigten Ausführungsbeispiel kann noch vorgesehen sein, dass die Teil-Ladungsträgergebiete 32 eine Kammstruktur bilden, so dass sich streifenförmige Lücken 34 ergeben. Allgemein können die Lücken 34 die Form eines beliebigen geschlossenen Polygones haben.

## Patentansprüche

1. Schaltungsanordnung mit einem DMOS-Transistor, die ein im Driftgebiet (14) des OMOS-Transistors (10) angeordnetes Ladungsträgergebiet (30) umfasst, das aus einzelnen beabstandet zueinander angeordneten und leitfähig miteinander verbundenen Teil-Ladungsträgergebieten (32) besteht, wobei das Ladungsträgergebiet (30) gegenüber dem Driftgebiet (14) eine entgegengesetzte Ladungsträgerdotierung aufweist, **dadurch gekennzeichnet, dass** zur Verpolsicherung des DMOS-Transistors das Ladungsträgergebiet (30) mit einem Potential derart beaufschlagbar ist, dass sich eine Sperrpolung zwischen den Teil-Ladungsträgergebieten (32) und dem Driftgebiet (14) ausbildet, wenn am Sourceanschluss (26) des DMOS-Transistors eine höhere Spannung als an seinem Drainanschluss (24) anliegt.

2. Schaltungsanordnung nach Anspruch 1, **dadurch gekennzeichnet, dass** die Teil-Ladungsträgergebiete (32) gitterartig angeordnet sind und Lücken (34) des Driftgebietes (14) umschliessen.

3. Schaltungsanordnung nach einem der vorhergehenden Ansprüche, **dadurch gekennzeichnet, dass** das Ladungsträgergebiet (30) über ein vertikales Ladungsträgergebiet (36) mit einer Metallisierung (38) verbunden ist.

4. Schaltungsanordnung nach einem der vorhergehenden Ansprüche, **dadurch gekennzeichnet, dass** das Ladungsträgergebiet (30) innerhalb des Driftgebietes (14) zwischen zwei Ladungsträgerschichten (56, 58) angeordnet ist, wobei die Ladungsträgerschichten (56, 58) den gleichen Ladungsträgertyp wie das Driftgebiet (14) besitzen, jedoch höher dotiert sind.

5. Schaltungsanordnung nach einem der vorhergehenden Ansprüche, **dadurch gekennzeichnet, dass** die Teil-Ladungsträgergebiete (32) in zwei Ebenen angeordnet sind.

6. Schaltungsanordnung nach Anspruch 5, **dadurch gekennzeichnet, dass** die Teil-Ladungsträgergebiete (32) der zwei Ebenen versetzt zueinander angeordnet sind.

7. Schaltungsanordnung nach Anspruch 2, **dadurch gekennzeichnet, dass** die Lücken (34) zwischen den Teil-Ladungsträgergebieten (32) rund sind.

8. Schaltungsanordnung nach Anspruch 2, **dadurch gekennzeichnet, dass** die Lücken (34) zwischen den Teil-Ladungsträgergebieten (32) quadratisch sind.

9. Schaltungsanordnung nach Anspruch 2, **dadurch gekennzeichnet, dass** die Lücken (34) zwischen den Teil-Ladungsträgergebieten (32) streifenförmig sind.

10. Schaltungsanordnung nach Anspruch 2, **dadurch gekennzeichnet, dass** die Lücken (34) zwischen den Teil-Ladungsträgergebieten (32) die Form eines geschlossenen Polygones haben.

## Claims

1. Circuit arrangement comprising a DMOS transistor, which circuit arrangement comprises a charge carrier region (30) arranged in the drift region (14) of the DMOS transistor (10) and consisting of individual partial charge carrier regions (32) arranged at a distance from one another and conductively connected to one another, wherein the charge carrier region (30) has an opposite charge carrier doping relative to the drift region (14), **characterized in that**, in order to protect the DMOS transistor against polarity reversal, a potential can be applied to the charge carrier region (30) in such a way that a reverse-biasing forms between the partial charge carrier regions (32) and the drift region (14) if the voltage present at the source terminal (26) of the DMOS transistor is higher than that present at the drain terminal (24) of said DMOS transistor.

2. Circuit arrangement according to Claim 1, **characterized in that** the partial charge carrier regions (32) are arranged in a grid-like manner and enclose gaps (34) of the drift region (14).

3. Circuit arrangement according to either of the preceding claims, **characterized in that** the charge carrier region (30) is connected to a metallization (13) via a vertical charge carrier region (36).

4. Circuit arrangement according to any of the preceding claims, **characterized in that** the charge carrier region (30) is arranged within the drift region (14) between two charge carrier layers (56, 58) wherein the charge carrier layers (56, 58), have the same charge carrier type as the drift region (14) but are more highly doped.

5. Circuit arrangement according to any of the preceding claims, **characterized in that** the partial charge carrier regions (32) are arranged in two planes.

6. Circuit arrangement according to Claim 5, **characterized in that** the partial charge carrier regions (32) of the two planes are arranged in the manner offset with respect to one another.

7. Circuit arrangement according to Claim 2, **characterized in that** the gaps (34) between the partial charge carrier regions (32) are round.

8. Circuit arrangement according to Claim 2, **characterized in that** the gaps (34) between the partial charge carrier regions (32) are square.

9. Circuit arrangement according to Claim 2, **characterized in that** the gaps (34) between the partial charge carrier regions (32) are in strip form.

10. Circuit arrangement according to Claim 2, **characterized in that** the gaps (34) between the partial charge carrier regions (32) have the form of a closed polygon.

## Revendications

1. Agencement de circuit avec un transistor DMOS qui comprend une zone de support de charge (30) disposée dans la zone de dérive (14) du transistor DMOS (10), ladite zone se composant de zones de support de charge partielles (32) individuelles espacées les unes par rapport aux autres et reliées entre elles de façon conductrice, la zone de support de charge (30) comportant une dotation de support de charge opposée par rapport à la zone de dérive (14), **caractérisé en ce que** la zone de support de charge (30) peut être chargée avec un potentiel tel, en vue d'apporter une protection contre les inversions de polarité du transistor DMOS, qu'on provoque un blocage de polarité entre les zones de support de charge partielles (32) et la zone de dérive (14) en présence d'une tension plus élevée au niveau du raccord de source (26) du transistor DMOS qu'au niveau de son raccord de drain (24).

2. Agencement de circuit selon la revendication 1, **caractérisé en ce que** les zones de support de charge partielles (32) sont disposées à la façon d'une grille et englobent les espaces vides (34) de la zone de dérive (14).

3. Agencement de circuit selon l'une quelconque des revendications précédentes, **caractérisé en ce que** la zone de support de charge (30) est reliée à une métallisation (38) par le biais d'une zone de support de charge (36) verticale.

4. Agencement de circuit selon l'une quelconque des revendications précédentes, **caractérisé en ce que** la zone de support de charge (30) est disposée à l'intérieur de la zone de dérive (14) entre deux couches de support de charge (56, 58), les couches de support de charge (56, 58) possédant le même type de support de charge que la zone de dérive (14), avec toutefois une dotation plus élevée.

5. Agencement de circuit selon l'une quelconque des revendications précédentes, **caractérisé en ce que** les zones de support de charge partielles (32) sont disposées dans deux plans.

6. Agencement de circuit selon la revendication 5, **caractérisé en ce que** les zones de support de charge partielles (32) des deux plans sont disposées de façon décalée l'une par rapport à l'autre.

7. Agencement de circuit selon la revendication 2, **caractérisé en ce que** les espaces vides (34) situés entre les zones de support de charge partielles (32) sont ronds.

8. Agencement de circuit selon la revendication 2, **caractérisé en ce que** les espaces vides (34) situés entre les zones de support de charge partielles (32) sont carrés.

9. Agencement de circuit selon la revendication 2, **caractérisé en ce que** les espaces vides (34) situés entre les zones de support de charge partielles (32) prennent la forme de bandes.

10. Agencement de circuit selon la revendication 2, **caractérisé en ce que** les espaces vides (34) situés entre les zones de support de charge partielles (32) prennent la forme d'un polygone fermé.
